# EUROPEAN PATENT APPLICATION

(11) **EP 4 797 939 A1**
(43) Date of publication of application: **26.08.2026**
(21) Application number: 26156495.9
(22) Date of filing: 05.02.2026
(51) Int. Cl.: H10W 74/10, H10W 70/40, H10W 72/30, H10W 70/04

(54) **LASER TEXTURING OF SEMICONDUCTOR DIE AND LEAD FRAME FOR MOLDING MATERIAL ADHESION ENHANCEMENT IN SEMICONDUCTOR PACKAGE**

(30) Priority: 21.02.2025 US 202519059860
(71) Applicant: Tesla, Inc., Austin, TX 78725 (US)
(72) Inventor: Chi, William Thomas, Austin, Texas, 78725 (US); Wang, Hongliang, Austin, Texas, 78725 (US)
(74) Representative: Liesegang, Eva

(57) **Abstract**

The present disclosure is directed to a semiconductor package. The semiconductor package includes a semiconductor die comprising a transistor, a lead frame having a surface on which the semiconductor die is at least partly stacked, and a molding material over the lead frame and encapsulating the semiconductor die. The surface includes a textured pattern at an interface with the molding material, and the textured pattern includes an array of features having less than 1000 micrometers between two adjacent features of the array of features.

## Description

### BACKGROUND

### Technical Field

This disclosure relates to semiconductor packages. In particular, embodiments of this disclosure relate to semiconductor packages with improved adhesion between structures.

### Description of Related Technology

Semiconductor devices are used in a wide variety of applications. In some applications, semiconductor devices can incorporate multiple electrical components that are attached to a frame (or body of the semiconductor devices) and electrically connected with each other. Such electrical attachment can encounter undesired delamination in certain applications. There may be technical problems associated with the delamination, such as defects and chips over heated in the semiconductor device operations.

### SUMMARY

The innovations described in the claims each have several aspects, no single one of which is solely responsible for its desirable attributes. Without limiting the scope of the claims, some prominent features of this disclosure will now be briefly described.

One aspect of this disclosure is a semiconductor package that includes a semiconductor die, having a transistor, a lead frame, having a surface on which the semiconductor die is at least partly stacked, and a molding material over the lead frame. The surface includes a textured pattern that includes an array of features, having less than 1000 micrometers between two adjacent features of the array of features. The molding material is encapsulating the semiconductor die, where the textured pattern being at an interface with the molding material.

In the semiconductor package, the semiconductor die can be soldered to the surface of the lead frame.

In the semiconductor package, the surface of lead frame further can include a second textured pattern positioned closer to an edge of the surface of the lead frame than the textured pattern. Additionally, a side of the semiconductor die, opposite to the surface of the lead frame, can include a third textured pattern, where the molding material can cover the second textured pattern and the third textured pattern.

In the semiconductor package, the textured pattern can be generated using a laser.

In the semiconductor package, each feature of the array of features can have a dimple shape having a depth of at least 1 micrometer.

Another aspect of this disclosure is a method of manufacturing a semiconductor package. The method includes roughing an area of a surface of a lead frame using a laser, soldering a semiconductor die to the surface, and encapsulating the semiconductor die with molding material. At least part of the area of the surface is in contact with the molding material after the encapsulation.

In the method, the method can further include determining a shape of the area of the surface for roughening.

In the method, the method can further include roughening a top surface of the semiconductor die. The roughened top surface of the semiconductor die and the molding material can be in contact after the encapsulation.

In the method, the area can include an array of features, having less than 1000 micrometers between two adjacent features of the array of features.

In another aspect, the semiconductor package includes a semiconductor die, having a first side and a second side opposite the first side, a molding material encapsulating the semiconductor die, and a lead frame at least partly stacked with the semiconductor die, where the first side of the semiconductor die is facing a surface of the lead frame. The second side includes a first textured pattern. The surface of the lead frame includes a second textured pattern and a third textured pattern, where the molding material being in contact with first, second, and third textured patterns.

In the semiconductor package, the second textured pattern can surround the semiconductor die, and the third textured pattern can surround the second textured pattern.

In the semiconductor package, each of the first, second, and third textured patterns can include an array of features having a pitch of 1000 micrometers or less.

In the semiconductor package, the semiconductor die can be soldered to the surface of the lead frame.

In the semiconductor package, the third textured pattern can be positioned closer to an edge of the surface of the lead frame than the second textured pattern.

In the semiconductor package, the semiconductor package can further include a fourth textured pattern on a surface of a lead post, where the fourth textured pattern and the first textured patterns can be connected by a wire bond.

In the semiconductor package, the first, second, and third textured patterns can be generated using a laser.

In the semiconductor package, the second textured pattern can include an array of dimples. Additionally, each dimple of the arrays can have a depth of at least 1 micrometer.

In the semiconductor package, each of the first, second, and the third textured patterns can include an array of features, and each feature of the array of the second textured pattern can have a greater depth than each feature of the arrays of the first and third textured patterns.

For purposes of summarizing the disclosure, certain aspects, advantages, and novel features of the innovations have been described herein. It is to be understood that not necessarily all such advantages may be achieved in accordance with any particular embodiment. Thus, the innovations may be embodied or carried out in a manner that achieves or optimizes one advantage or group of advantages as taught herein without necessarily achieving other advantages as may be taught or suggested herein.

### BRIEF DESCRIPTION OF THE DRAWINGS

These and other features, aspects, and advantages of the disclosure are described with reference to the drawings of certain embodiments. It is to be understood that the accompanying drawings, which are incorporated in and constitute a part of this specification, are for the purpose of illustrating concepts disclosed herein and do not be to scale.
FIG. 1 is an example of a semiconductor package in accordance with the present disclosure;
FIG. 2 is an example of a semiconductor package with textured patterns in accordance with the present disclosure;
FIG. 3A is an example of textured patterns with an array of dimple features;
FIG. 3B is an example of textured patterns with an array of circular features; and
FIG. 4 illustrates an example of a laser system and various surfaces of textured patterns.

### DETAILED DESCRIPTION

The following detailed description of certain embodiments presents various descriptions of specific embodiments. However, the innovations described herein can be embodied in a multitude of different ways, for example, as defined and covered by the claims. In this description, reference is made to the drawings where like reference numerals and/or terms can indicate identical or functionally similar elements. It will be understood that elements illustrated in the figures are not necessarily drawn to scale. Moreover, it will be understood that certain embodiments can include more elements than illustrated in a drawing and/or a subset of the elements illustrated in a drawing. Further, some embodiments can incorporate any suitable combination of features from two or more drawings. The headings provided herein are for convenience only and do not necessarily affect the scope or meaning of the claims.

### Introduction

Electronic components containing one or more semiconductor dies can be deployed in a wide variety of applications. For example, such components can form part of a power electronics system. In some cases, such power electronics systems can be used to provide power for a heating, ventilation, and air conditioning (HVAC) system, an electric vehicle, and so forth. For example, in an electric vehicle, such systems can be used to convert alternating current to direct current for charging, from direct current to alternating current, or direct current at a first voltage to direct current at a second, different voltage to provide power output. Power electronics systems can also be used as part of a stationary energy storage system, such as a system for storing solar energy or for other applications where there is a need for power delivery. A power electronics system can be used, for example, to convert direct current from a solar panel or battery to alternating current. In some cases, such power electronics systems can be used in utility applications, such as a grid-tie inverter that converts direct current to alternating current for insertion into an electrical power grid. These are merely examples, and there can be many other applications for such systems. In some cases, components of such systems can comprise diode switches, field effect transistors (FETs) such as metal-oxide-semiconductor field effect transistors (MOSFETs) (e.g., GaN MOSFETs), insulated-gate bipolar transistors (IGBTs), other bipolar transistors, the like, or any suitable combination thereof. In certain applications, such switches can be included in an inverter that converts a direct current (DC) voltage to an alternating current (AC) voltage. These components can have significant heat output when operational.

Various techniques are used to attach semiconductor components, such as the semiconductor die, during the device assembly process. Common methods include soldering and applying epoxy as bonding agents. However, the significant heat generated during the operation of semiconductor devices can lead to the detachment of these components. For instance, excessive heat may cause delamination of the solder or epoxy, resulting in the separation of the semiconductor die. To improve the reliability of semiconductor packages, it is desirable to strengthen the attachment of these components. Embodiments of this disclosure present solutions to enhance the bonding and attachment of semiconductor components, thereby increasing the durability and performance of the devices.

In some methods, a mold compound is used to enhance the bonding strength of semiconductor components. For instance, during the assembly process, the semiconductor components can be bonded to the surface of a substrate, and then the mold compound can be applied over the components. However, the interfaces between the mold compound and the semiconductor components (or the substrate) may be prone to heat-induced issues during the operation of the semiconductor components. This heat can lead to delamination at these interfaces, potentially causing damage to the semiconductor components or their detachment from the substrate.

This disclosure presents technical solutions to address one or more of the aforementioned challenges and/or other technical issues. For instance, aspects of the present disclosure relate to a semiconductor package that includes a textured pattern designed to prevent delamination of semiconductor components (e.g., semiconductor dies) during operation. These textured patterns, incorporated into one or more surfaces of the semiconductor package, can improve the bonding strength between components and mitigate delamination risks. The principles and advantages of these technical solutions can be implemented in any suitable combination within a semiconductor package to achieve enhanced performance and reliability.

### Semiconductor Device

Aspects of this disclosure relate to a semiconductor package, such as semiconductor chip packages or semiconductor integrated circuit (IC) packages, which include enhanced bonding methods for semiconductor components. In particular, these semiconductor packages can include textured patterns formed on molding surfaces to increase surface roughness and strengthen their respective bonds. As disclosed herein, the molding surfaces can refer to interfaces between the molding material and another surface, such as interfaces between molding material and a surface of lead frame (e.g., a surface of die paddle included in the lead frame), a surface of bonding material (e.g., a surface of bonding material printed on one or more portions of the lead frame), and a surface of a semiconductor die (e.g., top surface of the semiconductor die). In some examples, the textured patterns can be formed by using a laser. For example, with laser roughening disclosed herein, a textured pattern can be formed that includes an array of features having less than 1000 micrometers between two adjacent features of the array of features. In some such textured patterns, an array of features has less than 100 micrometers between two adjacent features. For the purpose of description, the laser is utilized to form the textured patterns in certain embodiments. However, any suitable machine, device, or method can be used for form textured patterns disclosed herein, such as electron beams, mechanical tooling device (e.g., knurling or micro-stamping patterning device), or the like.

As disclosed herein, the bonding surfaces can be portions of a conductive structure in the semiconductor device that attach to the semiconductor die. For example, a lead frame may be used as the conductive structure, where a portion of the lead frame supports and bonds with the semiconductor die, and each lead is connected to a corresponding terminal of the die. For example, if the semiconductor die comprises a metal oxide field effect transistor (MOSFET) with drain, source, and gate terminals, the lead frame can include both the section that bonds with the semiconductor die and the individual leads connected to each of those terminals. Bonding surfaces thus can encompass the areas of the lead frame to which the semiconductor die is attached, as well as the lead segments where connectors (e.g., wires) join the leads to the die terminals. In some embodiments, a thermally conductive material, such as aluminum, may be bonded to the top of the semiconductor die to dissipate heat. A solder paste or epoxy can be applied to the bonding surface, and any material that extends beyond the die footprint forms an overflow region.

In some examples, a molding structure is placed over a portion of the lead frame. Molding material (e.g., molding resin) can be applied to encapsulate the semiconductor die and any adjacent areas of the lead frame. For the purpose of description, these interfaces are referred to as molding surfaces. In semiconductor assembly, semiconductor die attachment can involve mechanically and thermally coupling a semiconductor die to a lead frame. For example, the lead frame can include a die paddle on a portion of its surface, providing a platform for attaching the semiconductor die. Encapsulation, such as encapsulating with epoxy molding materials (e.g., molding compound), can protect the semiconductor die from environmental and mechanical stresses. Poor adhesion between the semiconductor die and the lead frame or between the molding material and internal surfaces can lead to failures such as delamination and/or cracking. To address thermal stress, the molding helps to disperse heat generated by the semiconductor die, promoting more uniform temperature distribution and reducing thermal gradients. Moreover, a rigid molding resin can lock the semiconductor die in place, impeding physical movement and reinforcing the device's structural integrity, thus improving reliability and durability.

In some aspects, the present disclosure discloses creating textured patterns on one or more surfaces in a semiconductor package. The one or more surfaces can include a surface of a lead frame or a surface of a semiconductor die. These texture patterns can roughen the one or more surfaces, thereby reducing the risk of delamination caused by thermal and/or mechanical stress. For instance, roughening the surface of the lead frame in an overflow region (e.g., solder overflow region) surrounding the semiconductor die can improve the bonding with the molding material by reducing potential detachment during manufacturing and/or during use of the semiconductor die. Roughening the molding surfaces, such as the interface between the molding material and the semiconductor die or between the lead frame and the molding material, can mitigate thermal and/or mechanical stress failures. The lead frame itself can be fabricated from any suitable conductive material, including copper or copper alloys. In some examples, any suitable interposer can be used as the substrate of the semiconductor packages.

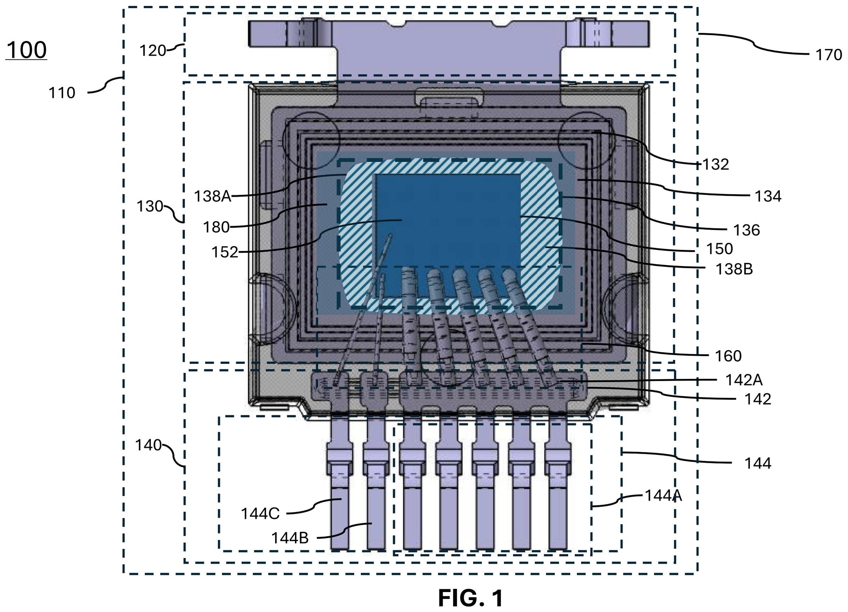

FIG. 1 illustrates a top view of an example of a semiconductor package 100 according to embodiments of this disclosure. As illustrated in FIG. 1, the semiconductor package 100 can include a lead frame 110, having an upper portion 120, a center portion 130, and a lower portion 140. The lead frame 110 can include a conductive material, such as copper. For the purpose of description, even though the lead frame 110 is illustrated with the upper portion 120, the center portion 130, and the lower portion 140, the present disclosure does not limit the orientation of the lead frame 110.

In some embodiments, the center portion 130 can include a trench 132, surrounding the outer of the center portion 130. In some examples, the center portion 130 within the trench 132 can be referred to as a die paddle 134. In some cases, the die paddle 134 can be enclosed by an enclosure (not shown in FIG. 1). For example, the enclosure can be clipped to the trench 132. In some cases, the enclosure can include thermally conductive material, such that the heat generated from the semiconductor die can be dissipated.

As shown in FIG. 1, the center portion 130 (e.g., the die paddle 134) can include a semiconductor die bonding region 136, where a semiconductor die 150 is bonded. For instance, a bonding layer 138A is applied to the surface of the semiconductor bonding region 136, and the semiconductor die 150 is bonded on top of the bonding layer 138A. In some cases, the bonding layer 138A has a larger area than the semiconductor die 150, allowing the semiconductor die 150 to be bonded to a portion of the bonding layer 138A. For example, after bonding the semiconductor die 150, the bonding layer 138A may extend beyond the edges of the semiconductor die 150, forming an overflow region 138B surrounding the semiconductor die 150. The portion of the bonding layer 138A outside the semiconductor die 150 can be referred to as the overflow region 138B. In some examples, the bonding layer 138A may include bonding material, such as solder paste, epoxy, or silver paste.

In some examples, the overflow region 138B can serve to accommodate excess bonding material during the semiconductor die bonding process to ensure adhesion between the semiconductor die 150 and the lead frame 110 (e.g., on the center portion 130 or die paddle 134). For example, when the semiconductor die 150 is mounted onto the center portion 130 of the lead frame 110, excess material may spread beyond the semiconductor die 150. In some examples, the overflow region 138B can be designed to contain this excess bonding material, maintaining a clean and controlled bonding process. This overflow region 138B can be isolated from electrically active components to prevent unintended electrical connections or short circuits. In some examples, the overflow region 138B can ensure the mechanical and thermal integrity of the semiconductor package 100.

In some embodiments, another bonding layer (e.g., semiconductor die top bonding layer 152) can be disposed on top of the semiconductor die 150. In some embodiments, the semiconductor die top bonding layer 152 can be coated with a thermal conductive material, such as an aluminum or aluminum nitride. The coated thermal conductive material can have a higher thermal conductivity with electrical insulation such that the heat generated from the semiconductor die 150 can be dissipated to the enclosure (not shown in FIG. 1) via the coated thermal conductive material.

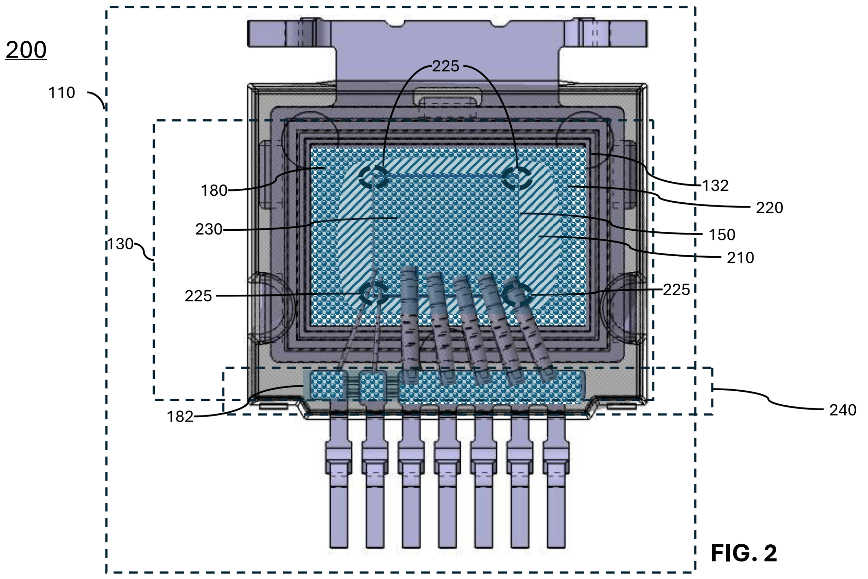

In some examples, one or more wire bonds 160 can be used to connect the semiconductor die 150 and the lower portion 140 of the lead frame 110. For example, the lower portion 140 can include a lead post 142 connected with the wire bonds 160. As further illustrated in FIG. 1, the lead post 142 is connected with lead 144 such that the leads 144 extends from the lead post 142. For example, one or more of the wire bonds 160 are utilized to connect source terminals of the semiconductor die 150 to the leads 144A. Further in this example, a wire is connected to the lead 144B and 144C by connecting a kelvin source terminal (e.g., a terminal used to measure the voltage of the semiconductor die 114) and the gate terminal of the semiconductor die 150, respectively. In some examples, the lead post 142 can include a bonding layer (e.g., lead post bonding layer 142A shown in FIG. 2) on top of the lead post 142. In some examples, the wire bonds 160 connect terminals of the semiconductor die 150 and the leads 144 by electrically connecting the semiconductor die top bonding layer 152 and the lead post bonding layer 142A.

In some embodiments, a molding material (or molding compound) 180 can be disposed within and/or over the die paddle 134 such that the molding material interfaces with the top of the semiconductor die 150 (e.g., semiconductor die top bonding layer 152), the top of overflow region 138B, and the die paddle 134. The molding material 180 can be over the semiconductor die 150 and overflow region 138B, although FIG. 1 does not show this to show underlying components. In some examples, the molding material 180 is a polymeric compound or an epoxy mold compound. The molding material 180 can encapsulate the semiconductor die 150, wire bonds 160, the overflow region 138B, and the die paddle 134. In some examples, the molding material 180 can include liquid molding compounds (e.g., silicone-based compounds), having low-viscosity materials.

FIG. 2 illustrates a top view of a semiconductor package 200, including textured patterns. These textured patterns can be formed using a laser, for example. Using a laser to form a textured pattern, the textured pattern can include an array of features having less than 100 micrometers between two adjacent features of the array. As shown in FIG. 2, the surface of the overflow region 138B of FIG. 1 can include an overflow region textured pattern 210, and the surface of the die paddle 134 of FIG. 1 can include a die paddle textured pattern 220. In some embodiments, the semiconductor package 200 can include a semiconductor die top textured pattern 230 on the surface of the semiconductor die top bonding layer 152 of FIG. 1. In addition, the semiconductor package 200 can also include a lead post textured pattern 240 on the surface of the lead post bonding layer 142A of FIG. 1.

In some embodiments, these textured patterns (e.g., the overflow region textured pattern 210, the die paddle textured pattern 220, the semiconductor die top textured pattern 230, and the lead post textured pattern 240) can have roughened surfaces. For example, these textured patterns can roughen the corresponding surfaces to enhance adhesion with the molding material 180 such that this surface treatment can improve the bonding strength, ensuring greater reliability and durability of the semiconductor package 200. In some examples, these textured patterns are formed on the surface of the center portion 130 of the lead frame 110. For example, the bonding layer 138A (shown in FIG. 1) can be applied on the surface of the center portion 130, and can form the overflow region textured pattern 210. In this example, the die paddle textured pattern 220 can have the textured pattern. In some examples, the surface of the semiconductor die top bonding layer 152 of FIG. 1, and the lead post bonding layer 142A of FIG. 1 can also have the textured pattern, generating the semiconductor die top textured pattern 230 and the lead post textured pattern 240, respectively.

In some embodiments, the overflow region textured pattern 210 can facilitate stronger adhesion between the center portion 130 of the lead frame 110 and the bonding layer 138A of FIG. 1 and also between the bonding layer 138A and the molding material 180 that covers the bonding layer with the overflow region textured pattern 210. In some examples, the die paddle textured pattern 220 can enhance bonding between the die paddle 134 of FIG. 1 and the molding material 180 that covers the die paddle with the die paddle textured pattern 220. In addition, the semiconductor die top textured pattern 230 can enhance the bonding between the top of the semiconductor die 150 and the molding material 180 that covers the top of the semiconductor die 150. Furthermore, in some cases, the bonding between the lead post 142 of FIG. 1 and a lead post molding material 182 (e.g., that covers the top of the lead post 142) can be enhanced by having the lead post textured pattern 240 on the surface of the lead post 142 of FIG. 1.

In various embodiments, these textured patterns can allow the molding material 180 to flow and settle uniformly, minimizing voids under the semiconductor die and enhancing thermal conduction and mechanical support. In particular, these textured patterns can improve adhesion and trap excess molding material 180 effectively, thereby increasing the overall reliability of the semiconductor die attachment and the semiconductor package. In some cases, these textured patterns can be created by utilizing a laser or an electron beam. For example, the laser or the electron beam can create one or more of the overflow region textured pattern 210, the die paddle textured pattern 220, the semiconductor die top textured pattern 230, and the lead post textured pattern 240. In some instances, each semiconductor package may have a unique geometry regarding the location of the semiconductor die 150. For example, the position of the semiconductor die 150 might be slightly misaligned within the center portion 130 of the lead frame 110, within an acceptable margin. In such cases, the precise location of the semiconductor die 150 can be determined before using a laser or electron beam to create the textured pattern. Similarly, the shape of the overflow region 138B of FIG. 1 may vary for each semiconductor package 200. The precise shape can also be identified prior to creating the textured pattern with a laser or electron beam. In some embodiments, the location of the semiconductor die 150 and the shape of the overflow region 138B of FIG. 1 can be predefined. Alternatively, the location of the semiconductor die 150 and the shape of the overflow region 138B can be specifically measured to ensure accuracy. The present disclosure does not limit the method or technique of measuring the location of the semiconductor die 150 and the shape of the overflow region 138B.

In some examples, the overflow region textured pattern 210, the die paddle textured pattern 220, the semiconductor die top textured pattern 230, and the lead post textured pattern 240 can include various features. The features, for example, can include, without limitations, a periodic dimple pattern, which consists of a uniform distribution of a plurality of dimples, a lattice pattern, a cross-hatch pattern, concentric circular or spiral patterns, linear parallel grooves (e.g., straight and evenly spaced lines), and the like. In some embodiments, these various features of the textured patterns can be generated by utilizing a laser or electron beams. In some embodiments, each of these various features can be included in an array, where there is a distance between two adjacent features of the array of less than 100 micrometers.

In some embodiments, one or more textured patterns of the overflow region textured pattern 210, the die paddle textured pattern 220, the semiconductor die top textured pattern 230, and the lead post textured pattern 240 can have dimple features. For example, the dimple features can be periodic dimples generated using a laser. For instance, the laser can generate the dimple features by specifying the parameters, such as a pitch and a depth. The pitch and depth of the dimples can be determined by a combination of laser parameters that govern how the laser interacts with the surface. The pitch refers to the distance between the centers of adjacent dimples in the textured pattern and is influenced by factors such as the frequency of laser pulses. Adjacent dimples of an array can have less than 100 micrometers therebetween. A higher pulse frequency can result in a tighter pitch (e.g., dimples are closer together). A lower pulse frequency can produce a wider pitch, spacing the dimples farther apart. The depth is the vertical measurement of the dimples and is controlled by parameters such as laser power and/or energy density. For instance, a higher laser power increases the energy delivered to the surface, resulting in deeper depth, while lower laser power can create shallower depth. In some cases, the laser pulse duration also influences depth such that the longer laser pulse duration produce the deeper depth of the dimple.

In some embodiments, the overflow region textured pattern 210, the die paddle textured pattern 220, the semiconductor die top textured pattern 230, and the lead post textured pattern 240 can share the same feature of a textured pattern. For instance, all these textured patterns may include dimple features. In such cases, a laser can be utilized to generate the dimple features by applying the same pulse frequency, power, and duration to create the overflow region textured pattern 210, the die paddle textured pattern 220, the semiconductor die top textured pattern 230, and the lead post textured pattern 240. For example, the laser parameters used to create these textured patterns may include a pulse frequency in the range of 1 kHz to 10 MHz, a laser power between 10 W and 2000 W, and a pulse duration in the range of 10 fs to 500 ns.

In some embodiments, the overflow region textured pattern 210, the die paddle textured pattern 220, the semiconductor die top textured pattern 230, and the lead post textured pattern 240 can have the same type of features with different profiles for each feature. In some examples, each of the overflow region textured pattern 210 and the die paddle textured pattern 220 can have a different textured profile. For example, the overflow region textured pattern 210 can have the dimple pattern created by using higher laser power than the dimple features of the die paddle textured pattern 220. Other textured patterns (e.g., the semiconductor die top textured pattern 230, and the lead post textured pattern 240) can have dimple features created with different laser power. For example, the dimple features of the semiconductor die top textured pattern 230 can be created with a lower laser power (e.g., 5W-20W), and the lead post textured pattern 240 can include dimple patterns created with higher laser power (e.g., 250W-2000W).

In some examples, the overflow region textured pattern 210 can have the dimple patterns created with the higher laser power, and the die paddle textured pattern 220 can have the dimple patterns crated with low laser power. In some cases, the semiconductor die top textured pattern 230 and/or the lead post textured pattern 240 may not have the features.

In some examples, the overflow region textured pattern 210, the die paddle textured pattern 220, the semiconductor die top textured pattern 230, and the lead post textured pattern 240 can be created by using various laser power levels, such as a low power (e.g., 1 W-20 W), a moderate power (e.g., 20 W-250 W), or a high power (e.g., 250 W-3000 W). For example, the semiconductor die top textured pattern 230 and the lead post textured pattern 240 can have features generated by using the moderate power, the die paddle textured pattern 220 can have features generated by using the low power, and the overflow region textured pattern 210 can have features generated by using the high power.

In some embodiments, the higher laser power can be used to create textured patterns on the corners 225 of the semiconductor die 150. For example, a higher laser power (e.g., 150W-200W) can be used to create the features of the textured patterns on the corner 225. For instance, the dimple depth on the corners 225 can be deeper than other features of the other textured patterns to further enhance the bonding with the molding material 180 such that the more molding material 180 can be filled in the dimples (having higher depth) features on the corners 225. In some embodiments, a laser can also create the surrounding trench 132.

In some embodiments, each of the overflow region textured pattern 210, the die paddle textured pattern 220, the semiconductor die top textured pattern 230, and the lead post textured pattern 240 can have the same or different features. For example, the semiconductor die top textured pattern 230 can have circular features, and the overflow region textured pattern 210, the die paddle textured pattern 220, and the lead post textured pattern 240 can have the dimple features. In some cases, the overflow region textured pattern 210, the die paddle textured pattern 220, the semiconductor die top textured pattern 230, and the lead post textured pattern 240 can have circular features, and the corners 225 of the semiconductor die can have dimple features.

In some examples, one or more surfaces of the bonding layer 138A, the overflow region 138B, the die paddle 134, the semiconductor die top bonding layer 152, and the lead post bonding layer 142A of FIG. 1 may have clean surfaces without having the textured pattern. For example, the semiconductor die top bonding layer 152 and/or the lead post bonding layer 142A of FIG. 1 can have a clean surface without having the textured pattern.

Even though the present disclosure illustrates specific features of textured patterns, these features of the patterns are provided as examples, and the present disclosure is not limited to these features of textured patterns. In addition, the laser parameters disclosed in the present disclosure are merely provided as examples, and the present disclosure does not limit the laser parameters. For example, the features of the textured pattern can include a lattice feature, a cross-hatch feature, concentric circular or spiral features, linear parallel grooves (e.g., straight, and evenly spaced lines), and the like.

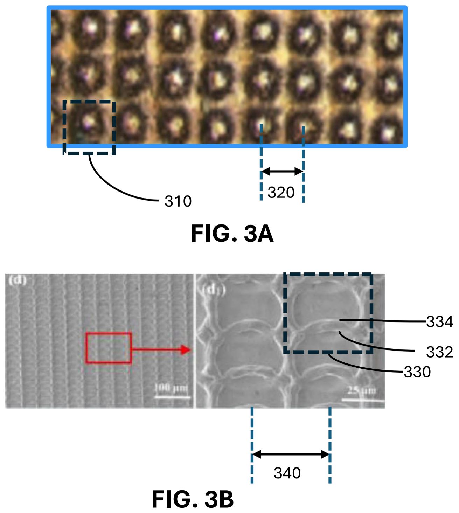

FIGs. 3A-3B illustrate examples of features of textured patterns that can be utilized in one or more of the overflow region textured pattern 210, the die paddle textured pattern 220, the semiconductor die top textured pattern 230, and the lead post textured pattern 240. Specifically, FIG. 3A illustrates an example of dimple features, and FIG. 3B illustrates an example of circular features. Even though FIGs. 3A-3B illustrate the specific dimple texture and circular features, these are illustrated as examples, and the present disclosure does not limit the types of textured patterns.

FIG. 3A illustrates an example of a dimple feature (e.g., an example array of dimples). The dimple features can include a plurality of dimples 310 arranged in an array. The distance between two dimples (e.g., the distance between two centers of adjacent dimples) can be referred to as a pitch. In some examples, when a laser is utilized to generate the dimple features of FIG. 3A, the laser pulse parameter can be correlated with the pitch. For example, a higher pulse frequency can result in a tighter pitch (e.g., dimples are closer together), whereas a lower pulse frequency can produce a wider pitch, spacing the dimples farther apart. In these embodiments, each dimple 310 can have a vertical depth (not shown in FIG. 3A). For example, each dimple can have at least 1 micrometer of the vertical depth. In some examples, the pitch between the dimples can be at or more than 10 micrometers. In some cases, the distance between two adjacent dimples of the array of dimples can be less than 1000 micrometers. The depth is the vertical measurement of the dimples and can be controlled by parameters such as laser power and/or energy density. For instance, a higher laser power increases the energy delivered to the surface, resulting in deeper depth, while a lower laser power can create shallower depth.

FIG. 3B illustrates an example of a circular feature (e.g., an example array of circles). The circular features can include a plurality of circular patterns 330 arranged in an array. The distance between two circles (e.g., the distance between two centers of adjacent circles) can be referred to as a pitch. In some examples, when a laser is utilized to generate the circular features of FIG. 3B, the laser pulse parameter can be correlated with the pitch. For example, a higher pulse frequency can result in a tighter pitch (e.g., circles are closer together), whereas a lower pulse frequency can produce a wider pitch, spacing the circles farther apart. In these embodiments, each circle 330 can have an inner ring 332 and an outer ring 334. In some examples, the circle 330 can be generated by creating the inner ring 332 and the outer ring 334, and then engraving the region defined between the inner ring 332 and the outer ring 334. In these examples, the depth of the engravement can be referred to as the depth of the circular pattern 330. In some cases, the size of the depth can be controlled by parameters such as laser power and/or energy density. For instance, a higher laser power increases the energy delivered to the surface, resulting in deeper depth, while a lower laser power can create shallower depth.

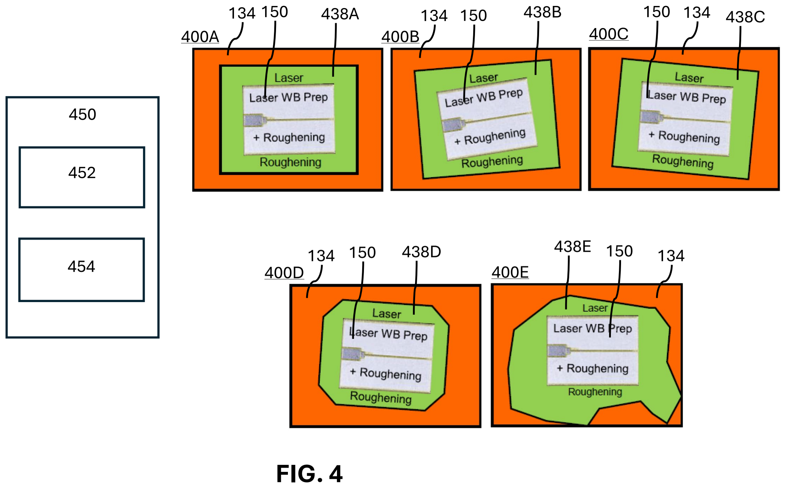

FIG. 4 illustrates an example of a laser system 450 and various surfaces of textured patterns 400A-400E. As shown in FIG. 4, the laser system 450 can include surface recognition module 452 and a laser beam module 454. In some examples, the surface recognition module 452 can determine the shape of the textured patterns. For example, as shown in various surfaces of textured patterns 400A-400E, a die paddle 134 can include an aligned rectangular overflow region 438A with a semiconductor die 150 (e.g., surface 400A), a left tilted rectangular overflow region 438B with a semiconductor die 150 (e.g., surface 400B), a right tilted rectangular overflow region 438C with a semiconductor die 150 (e.g., surface 400C), a polygon shape overflow region 438D with a semiconductor die 150 (e.g., surface 400D), and an irregular shape overflow region 438E with a semiconductor die 150 (e.g., surface 400E). In some examples, the surface recognition module 452 can detect these various shapes of overflow regions 438A-438E and the position of semiconductor die 150. For example, the surface recognition module 452 can recognize the edge of the semiconductor die 150 and also the shape of the overflow regions. For instance, the surface recognition module 452 can utilize an optical sensor, a laser beam, an electron beam, or the like to recognize the edge of the semiconductor die 150 and the shape of the overflow regions.

The semiconductor die 150 shown in FIG. 4 can have the semiconductor die top bonding layer 152 (shown in FIG. 1) with the semiconductor die top textured pattern 230 (shown in FIG. 2). For the purpose of description, applying the semiconductor die top bonding layer 152 (shown in FIG. 1) on top of the semiconductor die 150 can be referred to as a preparation step, and creating an array of features of the semiconductor die top textured pattern 230 (shown in FIG. 2) by using the laser system 450 can be referred to as the roughening step.

In some embodiments, the laser beam module 454 can form (e.g., etches) the features on the various surfaces of the semiconductor package, as disclosed herein. Example surfaces of the textured pattern and features are illustrated in FIGs. 1-3.

In some examples, after the surface recognition module 452 recognizes the location of the semiconductor die 150 and the surface of the overflow region, the laser beam module 454 can create features on the surfaces of one or more of the bonding layer 138A, the overflow region 138B, the die paddle 134, the semiconductor die top bonding layer 152, and the lead post bonding layer 142A (shown in FIG. 1) by generating the overflow region textured pattern 210, the die paddle textured pattern 220, the semiconductor die top textured pattern 230, and the lead post textured pattern 240, respectively. Such textured patterns and their features can roughen these surfaces.

In some examples, the semiconductor die 150 can be bonded on the die paddle by using solder or epoxy. Then, the molding material 180 (shown in FIGs. 1 and 2) can be encapsulated in the die paddle, such that one or more surfaces of the bonding layer 138A, the overflow region 138B, the die paddle 134, the semiconductor die top bonding layer 152, and the lead post bonding layer 142A (shown in FIG. 1) and their respective textured patterns (e.g., the overflow region textured pattern 210, the die paddle textured pattern 220, the semiconductor die top textured pattern 230, and the lead post textured pattern 240, shown in FIG. 2) can be in contact with the molding material 180 (shown in FIGs. 1 and 2).

### Additional Embodiments

In the foregoing specification, the disclosure has been described with reference to specific embodiments. It will, however, be evident that various modifications and changes may be made thereto without departing from the broader spirit and scope of the disclosure. The specification and drawings are, accordingly, to be regarded in an illustrative rather than restrictive sense.

Indeed, although this disclosure is in the context of certain embodiments and examples, it will be understood by those skilled in the art that the inventions extend beyond the specifically disclosed embodiments to other alternative embodiments and/or uses of the inventions and equivalents thereof. In addition, while several variations of the embodiments have been shown and described in detail, other modifications, which are within the scope of this disclosure, will be readily apparent to those of skill in the art based upon this disclosure. It is also contemplated that various combinations or sub-combinations of the specific features and aspects of the embodiments may be made and still fall within the scope of the disclosure. It should be understood that various features and aspects of the disclosed embodiments can be combined with, or substituted for, one another in order to form varying modes of the embodiments disclosed herein. Any methods disclosed herein need not be performed in the order recited. Thus, it is intended that the scope of the disclosure should not be limited by the particular embodiments described above.

It will be appreciated that the systems and methods of the disclosure each have several innovative aspects, no single one of which is solely responsible or required for the desirable attributes disclosed herein. The various features and processes described above may be used independently of one another or may be combined in various ways. All possible combinations and sub combinations are intended to fall within the scope of this disclosure.

Certain features that are described in this specification in the context of separate embodiments also may be implemented in combination in a single embodiment. Conversely, various features that are described in the context of a single embodiment also may be implemented in multiple embodiments separately or in any suitable sub combination. Moreover, although features may be described above as acting in certain combinations and even initially claimed as such, one or more features from a claimed combination may in some cases be excised from the combination, and the claimed combination may be directed to a sub combination or variation of a sub combination. No single feature or group of features is necessary or indispensable to each and every embodiment.

It will also be appreciated that conditional language used herein, such as, among others, "can," "could," "might," "may," "e.g.," and the like, unless specifically stated otherwise, or otherwise understood within the context as used, is generally intended to convey that certain embodiments include, while other embodiments do not include, certain features, elements and/or steps. Thus, such conditional language is not generally intended to imply that features, elements, and/or steps are in any way required for one or more embodiments or that one or more embodiments necessarily include logic for deciding, with or without author input or prompting, whether these features, elements and/or steps are included or are to be performed in any particular embodiment. The terms "comprising," "including," "having," and the like are synonymous and are used inclusively, in an open- ended fashion, and do not exclude additional elements, features, acts, operations, and so forth. In addition, the term "or" is used in its inclusive sense (and not in its exclusive sense) so that when used, for example, to connect a list of elements, the term "or" means one, some, or all of the elements in the list. In addition, the articles "a," "an," and "the" as used in this application and the appended claims are to be construed to mean "one or more" or "at least one" unless specified otherwise. Similarly, while operations may be depicted in the drawings in a particular order, it is to be recognized that such operations need not be performed in the particular order shown or in sequential order, or that all illustrated operations be performed, to achieve desirable results. Further, the drawings may schematically depict one or more example processes in the form of a flowchart. However, other operations that are not depicted may be incorporated in the example methods and processes that are schematically illustrated. For example, one or more additional operations may be performed before, after, simultaneously, or between any of the illustrated operations. Additionally, the operations may be rearranged or reordered in other embodiments. In certain circumstances, multitasking and parallel processing may be advantageous. Moreover, the separation of various system components in the embodiments described above should not be understood as requiring such separation in all embodiments, and it should be understood that the described program components and systems may generally be integrated together in a single software product or packaged into multiple software products. Additionally, other embodiments are within the scope of the following claims. In some cases, the actions recited in the claims may be performed in a different order and still achieve desirable results.

Further, while the methods and devices described herein may be susceptible to various modifications and alternative forms, specific examples thereof have been shown in the drawings and are herein described in detail. It should be understood, however, that the disclosure is not to be limited to the particular forms or methods disclosed, but, to the contrary, the disclosure is to cover all modifications, equivalents, and alternatives falling within the spirit and scope of the various implementations described and the appended claims. Further, the disclosure herein of any particular feature, aspect, method, property, characteristic, quality, attribute, element, or the like in connection with an implementation or embodiment can be used in all other implementations or embodiments set forth herein. Any methods disclosed herein need not be performed in the order recited. The methods disclosed herein may include certain actions taken by a practitioner; however, the methods can also include any third-party instruction of those actions, either expressly or by implication. The ranges disclosed herein also encompass any and all overlap, sub-ranges, and combinations thereof. Language such as "up to," "at least," "greater than," "less than," "between," and the like includes the number recited. Numbers preceded by a term such as "about" or "approximately" include the recited numbers and should be interpreted based on the circumstances (e.g., as accurate as reasonably possible under the circumstances, for example ±5%, ±10%, ±15%, etc.). Phrases preceded by a term such as "substantially" include the recited phrase and should be interpreted based on the circumstances (e.g., as much as reasonably possible under the circumstances). For example, "substantially constant" includes "constant." Unless stated otherwise, all measurements are at standard conditions including temperature and pressure.

As used herein, a phrase referring to "at least one of" a list of items refers to any combination of those items, including single members. As an example, "at least one of: A, B, or C" is intended to cover: A, B, C, A and B, A and C, B and C, and A, B, and C. Conjunctive language such as the phrase "at least one of X, Y and Z," unless specifically stated otherwise, is otherwise understood with the context as used in general to convey that an item, term, etc. may be at least one of X, Y or Z. Thus, such conjunctive language is not generally intended to imply that certain embodiments require at least one of X, at least one of Y, and at least one of Z to each be present. The headings provided herein, if any, are for convenience only and do not necessarily affect the scope or meaning of the devices and methods disclosed herein.

Accordingly, the claims are not intended to be limited to the embodiments shown herein but are to be accorded the widest scope consistent with this disclosure, the principles and the novel features disclosed herein.

## Claims

1. A semiconductor package comprising:
a semiconductor die comprising a transistor;
a lead frame having a surface on which the semiconductor die is at least partly stacked, the surface comprising a textured pattern, the textured pattern comprising an array of features having less than 1000 micrometers between two adjacent features of the array of features; and
a molding material over the lead frame and encapsulating the semiconductor die, the textured pattern being at an interface with the molding material.

2. The semiconductor package of claim 1, wherein the semiconductor die is soldered to the surface of the lead frame.

3. The semiconductor package of claim 1 or 2, wherein the surface of the lead frame further comprises a second textured pattern positioned closer to an edge of the surface of the lead frame than the textured pattern.

4. The semiconductor package of claim 3, where a side of the semiconductor die, opposite to the surface of the lead frame, comprises a third textured pattern, and wherein the molding material covers the second textured pattern and the third textured pattern.

5. The semiconductor package of one of the preceding claims, wherein the textured pattern is generated using a laser; and/or
wherein each feature of the array of features has a dimple shape having a depth of at least 1 micrometer.

6. A method of manufacturing a semiconductor package, the method comprising:
roughing an area of a surface of a lead frame using a laser;
soldering a semiconductor die to the surface; and
encapsulating the semiconductor die with molding material, wherein at least part of the area of the surface is in contact with the molding material after said encapsulating.

7. The method of claim 6, further comprising determining a shape of the area of the surface for roughening; and/or further comprising roughening a top surface of the semiconductor die, wherein the roughened top surface of the semiconductor die and the molding material are in contact after said encapsulation.

8. The method of claim 6 or 7, wherein the area comprises an array of features having less than 1000 micrometers between two adjacent features of the array of features.

9. A semiconductor package comprising:
a semiconductor die comprising a first side and a second side opposite the first side, the second side comprising a first textured pattern;
a molding material encapsulating the semiconductor die; and
a lead frame at least partly stacked with the semiconductor die, the first side of the semiconductor die facing a surface of the lead frame, the surface of the lead frame comprising a second textured pattern and a third textured pattern, the molding material being in contact with first, second, and third textured patterns.

10. The semiconductor package of claim 9, wherein the second textured pattern surrounds the semiconductor die, and wherein the third textured pattern surrounds the second textured pattern; and/or.
wherein each of the first, second, and third textured patterns comprises an array of features having a pitch of 1000 micrometers or less.

11. The semiconductor package of claim 9 or 10, wherein the semiconductor die is soldered to the surface of the lead frame.

12. The semiconductor package of one of claims 9 to 11, wherein the third textured pattern is positioned closer to an edge of the surface of the lead frame than the second textured pattern.

13. The semiconductor package of one of claims 9 to 12, further comprising a fourth textured pattern on a surface of a lead post, the fourth textured pattern and the first textured patterns are connected by a wire bond.

14. The semiconductor package of one of claims 9 to 13, wherein the first, second, and third textured patterns are generated using a laser; and/or
wherein the second textured pattern comprises an array of dimples, preferably wherein each dimple of the arrays has a depth of at least 1 micrometer.

15. The semiconductor package of one of claims 9 to 14, wherein each of the first, second, and third textured patterns comprises an array of features, and wherein each feature of the array of the second textured pattern has a greater depth than each feature of the arrays of the first and third textured patterns.
